# EUROPÄISCHE PATENTSCHRIFT

(11) **EP 4 371 864 B1**
(45) Veröffentlichungstag und Bekanntmachung des Hinweises auf die Patenterteilung: **14.05.2025**
(21) Anmeldenummer: 23204396.8
(22) Anmeldetag: 18.10.2023
(51) Int. Cl.: B62J 45/412, B62J 45/413, B62M 6/50

(54) **VERFAHREN ZUM ERMITTELN EINER TRITTFREQUENZ EINES FAHRRADS**
METHOD FOR DETERMINING A STEP RATE OF A BICYCLE
PROCÉDÉ DE DÉTERMINATION D'UNE FRÉQUENCE DE PÉDALAGE D'UNE BICYCLETTE

(30) Priorität: 18.11.2022 DE 102022212294
(43) Veröffentlichungstag der Anmeldung: 22.05.2024
(73) Patentinhaber: Robert Bosch GmbH, 70442 Stuttgart (DE)
(72) Erfinder: Manewald, Merlin Martin, 72764 Reutlingen (DE); Dauer, Felix, 72074 Tuebingen (DE); Pletinckx, Jo, 74372 Sersheim (DE); Stegmaier, Juergen, 72827 Wannweil (DE)

(56) Entgegenhaltungen:
- EP-B1- 2 433 097
- DE-A1- 102016 010 962
- KR-A- 20180 081 280
- US-A1- 2016 375 957
- US-A1- 2018 259 546

## Beschreibung

### Stand der Technik

Die vorliegende Erfindung betrifft ein Verfahren zum Ermitteln einer Trittfrequenz eines Fahrrads, und ein Fahrrad.

Bekannt ist die Erfassung von Trittfrequenzen an Fahrrädern mittels dedizierten Sensoren. Beispielsweise kann dabei ein üblicher Umdrehungssensor, wie ein Reed- Sensor verwendet werden. Die Erfassung der Trittfrequenz kann dabei aus rein informativen Zwecken erfolgen, beispielsweise um den Fahrer aus sportlicher Sicht relevante Informationen genau anzeigen zu können. Weiterhin bekannt ist insbesondere bei Elektrofahrrädern, welche eine Antriebseinheit zur Unterstützung eines durch einen Fahrer erzeugten Fahrerdrehmoments mittels Motorkraft aufweisen, die Bereitstellung des Motordrehmoments in Abhängigkeit verschiedener Parameter, wie unter anderem auch der Trittfrequenz, zu steuern.

### Offenbarung der Erfindung

Das erfindungsgemäße Verfahren mit den Merkmalen des Anspruchs 1 zeichnet sich dadurch aus, dass eine besonders einfache und kostengünstige Möglichkeit geschaffen wird, um eine Trittfrequenz an einem Fahrrad präzise zu ermitteln.

Insbesondere kann dabei auf zusätzliche Sensoren zur Einfassung der Trittfrequenz verzichtet werden. Dies wird erfindungsgemäß erreicht durch ein Verfahren zum Ermitteln einer Trittfrequenz eines Fahrrads, vorzugsweise eines Elektrofahrrads, umfassend die Schritte:
- Ermitteln eines Bewegungssignals, das einen zeitlichen Verlauf einer Fortbewegung des Fahrrads repräsentiert,
- Ermitteln eines Frequenzspektrums des Bewegungssignals, und
- Ermitteln einer Trittfrequenz basierend auf dem ermittelten Frequenzspektrum,
- Plausibilisieren des ermittelten Bewegungssignals mittels der ermittelten Trittfrequenz, insbesondere basierend auf einem vorbekannten Übersetzungsverhältnis eines Antriebs des Fahrrads,
- Ermitteln eines Phasenversatzes zwischen dem Bewegungssignal und einem Drehmomentsignal, das ein momentanes Fahrerdrehmoment oder ein Gesamtdrehmoment repräsentiert.

Mit anderen Worten wird bei dem Verfahren ein zeitlicher Verlauf einer Fortbewegung, wie beispielsweise eine Geschwindigkeit des Fahrrads, beispielsweise mittels eines Geschwindigkeitssensors, erfasst. Vorzugsweise erfolgt dies mittels einer hohen zeitlichen Auflösung, welche insbesondere ein Vielfaches einer maximal zu erwartenden Trittfrequenz, die ein Fahrer des Fahrrads üblicherweise tritt, beträgt. Die momentane Geschwindigkeit wird dabei beispielsweise durch das Bewegungssignal repräsentiert. Dieses Bewegungssignal wird bei dem Verfahren hinsichtlich seines Frequenzspektrums analysiert. Insbesondere können dabei charakteristische Frequenzanteile des Bewegungssignals bestimmt werden. Anhand des Frequenzspektrums wird anschließend die momentane Trittfrequenz, mit der ein Fahrer des Fahrrads die Pedale betätigt, ermittelt.

Insbesondere basiert die Ermittlung der Trittfrequenz dabei auf der Annahme, dass während der Pedalbetätigung durch den Fahrer die momentane Geschwindigkeit in Abhängigkeit des momentan mittels Muskelkraft aufgebrachten Tretmoments schwankt. Das Tretmoment ist dabei insbesondere von der momentanen Pedalstellung abhängig. Das heißt, wenn beispielsweise die Pedale horizontal stehen, tritt der Fahrer mit maximaler Tretkraft in die Pedale, sodass in dieser Stellung das maximale Tretmoment vorliegt, wobei in vertikaler Stellung der Pedale der Fahrer eine kleinere Tretkraft auf die Pedale aufbringt, sodass in dieser Stellung das minimale Tretmoment vorliegt. Diese Schwankungen des Tretmoments wirken sich auf die Beschleunigung und damit nachfolgend die Geschwindigkeit des Fahrrads aus. Durch die entsprechende Analyse des Bewegungssignals mittels des Verfahrens kann somit auf besonders einfache Weise und zuverlässig die momentane Trittfrequenz bestimmt werden. Dadurch ergeben sich auch weitere Vorteile. Beispielsweise kann bei Vorhandensein eines zusätzlichen Trittfrequenz-Sensors eine Validierung des damit erfassten Trittfrequenz-Signals erfolgen. Ferner kann beispielsweise eine Validierung eines Geschwindigkeitssignals erfolgen, insbesondere indem durch die zusätzliche Ermittlung der Trittfrequenz eine Überprüfung beider Parameter hinsichtlich Plausibilität erfolgen kann.

Die Unteransprüche zeigen bevorzugte Weiterbildungen der Erfindung.

Bevorzugt umfasst das Verfahren ferner den Schritt: Ermitteln einer charakteristischen Frequenz des Frequenzspektrums des Bewegungssignals. Das Ermitteln der Trittfrequenz erfolgt dabei basierend auf der ermittelten charakteristischen Frequenz. Als charakteristische Frequenz wird insbesondere ein dominanter Frequenzbereich des Frequenzspektrums angesehen, das heißt, eine Frequenz, die bei Zerlegung des Frequenzspektrums in seine einzelnen Frequenzanteile besonders dominant vorkommt. Damit kann auf besonders einfache Weise und zuverlässig die Frequenz anhand der erfassten Geschwindigkeit ermittelt werden.

Besonders bevorzugt wird die Trittfrequenz als halbe Frequenz der charakteristischen Frequenz ermittelt. Das heißt, die Trittfrequenz wird basierend auf der Annahme ermittelt, dass pro vollständiger Pedalumdrehung jedes der beiden Pedale genau einmal beispielsweise in der vertikalen Pedalstellung angeordnet ist, in der das maximale Fahrerdrehmoment aufgebracht wird.

Vorzugsweise wird das Ermitteln des Frequenzspektrums mittels einer schnellen Fourier-Transformation (kurz auch: FFT) durchgeführt. Damit kann die Analyse des Bewegungssignals hinsichtlich seiner charakteristischen Frequenzanteile, um das Frequenzspektrum zu ermitteln und daraus die Trittfrequenz abzuleiten, auf besonders einfache und effiziente Weise durchgeführt werden.

Weiter bevorzugt weist das Bewegungssignal ein Geschwindigkeitssignal auf. Vorzugsweise erfolgt das Ermitteln des Geschwindigkeitssignals mittels eines Geschwindigkeitssensors. Vorzugsweise ist der Geschwindigkeitssensor ein Reed-Sensor, insbesondere welcher als Magnetsensor ausgebildet ist. Bevorzugt erzeugt der Reed-Sensor pro Umdrehung eines Rades des Fahrrads einen Signalpuls, wobei basierend auf der Frequenz der Signalpulse und einem Radumfang des Rades die Geschwindigkeit ermittelt werden kann. Alternativ oder zusätzlich bevorzugt erfolgt das Ermitteln des Geschwindigkeitssignals mittels eines Antiblockier-Sensors eines Antiblockier-Systems des Fahrrads, beispielsweise mittels Tonewheel. Damit kann eine besonders hohe zeitliche Auflösung der Geschwindigkeit und damit eine besonders präzise Ermittlung der Trittfrequenz bereitgestellt werden.

Vorzugsweise weist das Bewegungssignal ein Beschleunigungssignal auf. Bevorzugt erfolgt das Ermitteln des Beschleunigungssignals mittels eines Beschleunigungssensors, insbesondere einer Inertialsensorik. Insbesondere kann mittels des Beschleunigungssensors eine Beschleunigung in Längsrichtung, das heißt beispielsweise in Fahrtrichtung, und/oder eine Beschleunigung einer Rollbewegung erfasst werden. Also Rollbewegung wird insbesondere eine Neigung um die Längsachse, welche in Fahrtrichtung ausgerichtet ist, angesehen. Dabei kann ebenfalls eine hohe zeitliche Auflösung und eine präzise Ermittlung der Trittfrequenz bereitgestellt werden.

Bevorzugt umfasst das Verfahren ferner die Schritte:
- Ermitteln einer Sensor-Trittfrequenz mittels eines Trittfrequenz-Sensors, und
- Validieren des Trittfrequenz-Sensors basierend auf einem Vergleich der ermittelten Trittfrequenz und der ermittelten Sensor-Trittfrequenz. Beispielsweise kann der Trittfrequenz-Sensor ein Umdrehungssensor sein, der eingerichtet ist, um eine Frequenz einer Pedalumdrehung bei einer Pedalbetätigung zu erfassen. Mit anderen Worten wird somit das sensorbasierte Trittfrequenzsignal des Trittfrequenz-Sensors und damit die korrekte Funktion des Trittfrequenz-Sensors mittels redundanter Ermittlung der Trittfrequenz validiert.

Das erfindungsgemässe Verfahren umfasst ferner den Schritt: Plausibilisieren des ermittelten Bewegungssignals mittels der ermittelten Trittfrequenz. Insbesondere erfolgt das Plausibilisieren basierend auf einem vorbekannten, beispielsweise momentanen, Übersetzungsverhältnis eines Antriebs des Fahrrads. Insbesondere wird als Übersetzungsverhältnis ein gesamtes Übersetzungsverhältnis zwischen einem Pedaltrieb und einem Hinterrad des Fahrrads angesehen. Mit anderen Worten kann somit bei bekanntem momentanen Übersetzungsverhältnis eine Umrechnung zwischen Geschwindigkeit und Trittfrequenz erfolgen. Beispielsweise kann dabei anhand der erfassten Geschwindigkeit und dem Übersetzungsverhältnis eine entsprechende zu erwartende Soll-Trittfrequenz berechnet werden. Durch die zusätzliche Ermittlung der Trittfrequenz basierend auf dem Frequenzspektrum des Bewegungssignals kann eine Übereinstimmung bzw. ein Abweichen der entsprechend ermittelten Trittfrequenzen erkannt werden, um basierend darauf auf einfache Weise und zuverlässig die Geschwindigkeitserfassung zu plausibilisieren. Beispielsweise kann eine Abweichung zwischen den jeweils ermittelten Trittfrequenzen aus Geschwindigkeit und Trittfrequenzsensor unter der Annahme einer korrekten Funktion des Trittfrequenzsensors auch als inkorrekte Geschwindigkeitserfassung gedeutet werden, was vorzugsweise zur Manipulationserkennung genutzt werden kann.

Besonders bevorzugt umfasst das Verfahren ferner den Schritt: Ermitteln einer Manipulation des Bewegungssignals im Ansprechen auf eine ermittelte Implausibilität des Bewegungssignals. Das heißt, wenn beim Plausibilisieren des Bewegungssignals anhand der Trittfrequenzen festgestellt wird, dass eine Implausibilität, insbesondere der jeweiligen Frequenzen vorliegt, so kann darauf geschlossen werden, dass eine Manipulation des Bewegungssignals vorliegt. Dies ist insbesondere im Falle von Elektrofahrrädern vorteilhaft, da hierdurch beispielsweise eine missbräuchliche Verwendung der manipulierten Geschwindigkeitserfassung vermieden werden kann.

Das erfindungsgemässe Verfahren umfasst ferner den Schritt: Ermitteln eines Phasenversatzes zwischen dem Bewegungssignal und einem Drehmomentsignal, das ein momentanes Fahrerdrehmoment repräsentiert, oder bevorzugt zwischen einem Bewegungssignal und dem Gesamtmoment aus gemessenem Fahrerdrehmoment und gestelltem Motormoment. Das Drehmomentsignal kann vorzugsweise mittels eines Drehmomentsensors erfasst werden. Damit können weitere vorteilhafte Informationen basierend auf dem Bewegungssignal über den momentanen Fahrzustand des Fahrrads gewonnen werden. Insbesondere ist der Phasenversatz dabei für eine Elastizität und/oder eine Trägheit des Antriebsstrangs repräsentativ, das heißt für ein Maß der Direktheit der Kraftübertragung. Beispielsweise ist bei höherer Elastizität der Phasenversatz größer, das heißt das Geschwindigkeitssignal eilt dem Drehmomentsignal umso stärker hinterher.

Bevorzugt wird das Plausibilisieren des ermittelten Bewegungssignals zusätzlich basierend auf dem ermittelten Phasenversatz durchgeführt. Beispielsweise kann dabei bei einem unerwarteten, das heißt implausiblen, Phasenversatz ebenfalls eine Manipulation des Geschwindigkeitssignals erkannt werden. In diesem Fall kann beispielsweise ein Vergleich des ermittelten Phasenversatzes mit einem vorbestimmten Referenzwert und/oder mit Kalibrierdaten und/oder mit einer Lookup-Tabelle erfolgen, um die Plausibilität des Phasenversatzes zu prüfen.

Weiterhin führt die Erfindung zu einem Verfahren zum Betreiben einer Antriebseinheit eines Elektrofahrrads. Die Antriebseinheit ist insbesondere eingerichtet, um ein mittels Muskelkraft eines Fahrers des Elektrofahrrads erzeugtes Fahrerdrehmoment motorisch mit einem Motordrehmoment zu unterstützen. Besonders bevorzugt erfolgt die Erzeugung des Motordrehmoments in Abhängigkeit vom Fahrparametern des Elektrofahrrads, insbesondere zumindest teilweise basierend auf einer momentanen Geschwindigkeit des Elektrofahrrads. Bevorzugt erfolgt die Erzeugung des Motordrehmoments nur bis zu einer vorbestimmten Maximalgeschwindigkeit. Das Verfahren zum Betreiben der Antriebseinheit umfasst dabei die Schritte:
- Ermitteln einer Trittfrequenz des Elektrofahrrads mittels des oben beschriebenen Verfahrens zum Ermitteln einer Trittfrequenz eines Fahrrads, und
- Betätigen der Antriebseinheit in Abhängigkeit der ermittelten Trittfrequenz. Insbesondere erfolgt dabei eine Regelung des erzeugten Motordrehmoments in Abhängigkeit der ermittelten Trittfrequenz. Dadurch kann die Antriebseinheit auf besonders einfache und effiziente Weise und besonders präzise angesteuert werden. Durch die spezielle Ermittlung der Trittfrequenz mittels des erfindungsgemäßen Verfahrens bietet sich dabei insbesondere der Vorteil, dass Manipulationen der Motorunterstützung, das heißt beispielsweise ein sogenanntes "Tuning", auf einfache und effektive Weise erkannt und/oder vermieden werden können.

Bevorzugt umfasst das Verfahren ferner den Schritt: Deaktivieren der Antriebseinheit im Ansprechen auf eine ermittelte Manipulation des Bewegungssignals, welche vorzugsweise wie oben beschrieben im Ansprechen auf eine ermittelte Implausibilität des Bewegungssignals ermittelt werden kann. Das heißt, im Falle einer ermittelten Manipulation des Bewegungssignals wird verhindert, dass mittels der Antriebseinheit ein Motordrehmoment erzeugt werden kann.

Ferner betrifft die Erfindung ein Fahrrad, umfassend einen Geschwindigkeitssensor und/oder eine Inertialsensorik zum Erzeugen eines Geschwindigkeitssignals, welches eine momentane Geschwindigkeit des Fahrrads repräsentiert, und eine Steuereinheit. Bevorzugt ist das Fahrrad ein Elektrofahrrad, welches bevorzugt ferner eine Antriebseinheit umfasst. In diesem Fall ist die Steuereinheit vorzugsweise ferner eingerichtet, die Antriebseinheit gesteuert zu betätigen. Die Steuereinheit ist dabei eingerichtet, das beschriebene Verfahren zum Ermitteln einer Trittfrequenz und/oder das beschriebene Verfahren zum Betreiben einer Antriebseinheit durchzuführen.

### Kurze Beschreibung der Zeichnungen

Nachfolgend werden Ausführungsbeispiele der Erfindung unter Bezugnahme auf die begleitende Zeichnung im Detail beschrieben. In der Zeichnung ist:
- Figur 1: eine vereinfachte schematische Ansicht eines Fahrrads bei dem ein Verfahren zum Ermitteln einer Trittfrequenz gemäß einem bevorzugten Ausführungsbeispiel der Erfindung durchgeführt wird,
- Figur 2: eine vereinfachte Darstellung von beispielhaften zeitlichen Verläufen von Sensorsignalen, welche bei der Durchführung des Verfahrens gemäß dem bevorzugten Ausführungsbeispiel verwendet werden,
- Figur 3: ein beispielhafter zeitlicher Verlauf eines Geschwindigkeitssignals, das bei der Durchführung des Verfahrens gemäß dem bevorzugten Ausführungsbeispiel verwendet wird,
- Figur 4: ein beispielhaftes Frequenzspektrum des Geschwindigkeitssignals der Figur 3, das bei der Durchführung des Verfahrens gemäß dem bevorzugten Ausführungsbeispiel verwendet wird, und
- Figur 5: beispielhafte zeitliche Verläufe eines gefilterten Drehmomentsignals und eines gefilterten Geschwindigkeitssignals, welche bei der Durchführung des Verfahrens gemäß dem bevorzugten Ausführungsbeispiel verwendet werden.

### Ausführungsformen der Erfindung

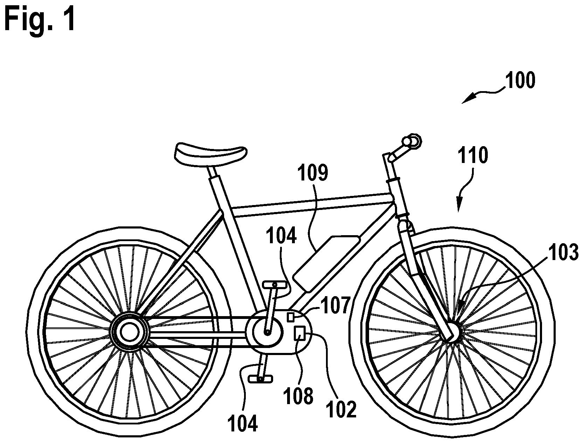

Figur 1 zeigt eine vereinfachte schematische Ansicht eines Fahrrads 100. Bei dem Fahrrad 100 handelt es sich um ein Elektrofahrrad, das eine Antriebseinheit 102 umfasst, welche als ein Elektromotor ausgebildet ist. Die Antriebseinheit 102 ist im Bereich eines Tretlagers des Fahrrads 100 angeordnet, und vorgesehen, um eine über einen Kurbeltrieb 104 aufgebrachte manuelle Tretkraft eines Fahrers des Fahrrads 100 durch ein elektromotorisch erzeugtes Drehmoment zu unterstützen.

Ferner umfasst das Fahrrads 100 einen elektrischen Energiespeicher 109, mittels welchem die Antriebseinheit 102 mit elektrischer Energie versorgbar ist. In die Antriebseinheit 102 ist außerdem eine Steuereinheit 108 integriert.

Die Steuereinheit 108 ist dabei eingerichtet, die Antriebseinheit 102 in Abhängigkeit einer Pedalbetätigung eines Fahrers des Fahrrads 100 zu betätigen. Im Detail wird die Antriebseinheit 102 derart gesteuert betätigt, dass in Abhängigkeit eines mittels Muskelkraft des Fahrers erzeugten Fahrerdrehmoments ein Motordrehmoment erzeugt wird, um den Fahrer beim Pedalieren motorisch zu unterstützen. Dabei ist vorgesehen, dass die Erzeugung des Motordrehmoments in Abhängigkeit einer Höhe des Fahrerdrehmoments gesteuert wird. Ferner kann die Betätigung der Antriebseinheit 102 von weiteren Parametern abhängen, wie beispielsweise einer Trittfrequenz.

Zudem erfolgt das Betätigen der Antriebseinheit 102 nur bis zu einer vorbestimmten Maximal-Geschwindigkeit, von vorzugsweise 25 km/h. Bei Überschreiten der vorbestimmten Maximal-Geschwindigkeit wird die Erzeugung des Motordrehmoments mittels der Antriebseinheit 102 gestoppt, beispielsweise durch Deaktivieren der Antriebseinheit 102.

Beim Betreiben der Antriebseinheit 102 wird dabei das Verfahren zum Ermitteln einer Trittfrequenz des Fahrrads 100 gemäß dem bevorzugten Ausführungsbeispiel der Erfindung durchgeführt. Die so ermittelte Trittfrequenz kann dabei verwendet werden, um auf einfache und zuverlässige Weise eine Manipulation der geschwindigkeitsabhängigen Ansteuerung der Antriebseinheit 102 zu erkennen und beispielsweise dem entgegen zu wirken. Dies wird nachfolgend im Detail beschrieben.

Bei dem Verfahren erfolgt zunächst ein Ermitteln eines Geschwindigkeitssignals 2 mittels eines Geschwindigkeitssensors 103. Der Geschwindigkeitssensor 103 ist im beschriebenen bevorzugten Ausführungsbeispiel ein Antiblockier-Sensor eines Antiblockiersystems 110 des Fahrrads 100. Damit kann das Geschwindigkeitssignal 2 besonders präzise und mit hoher zeitlicher Auflösung erfasst werden. Alternativ oder zusätzlich bevorzugt kann das Geschwindigkeitssignal 2 mittels eines Reed-Sensors als Geschwindigkeitssensor erfasst werden.

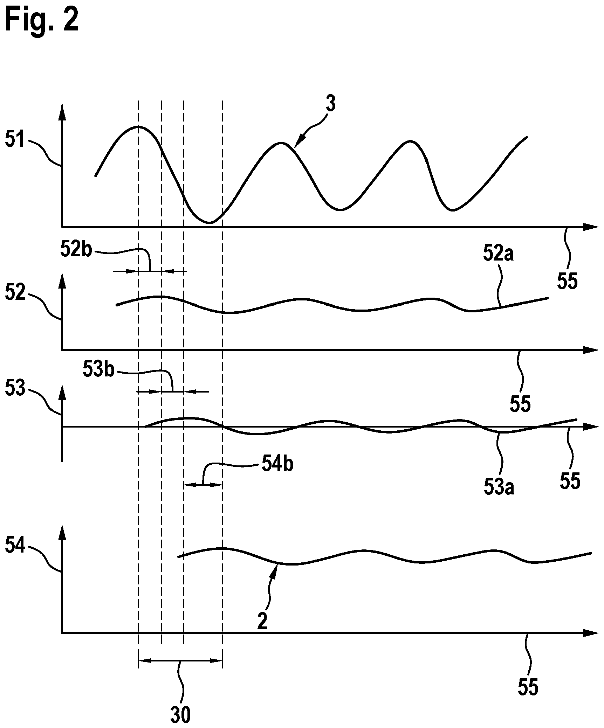

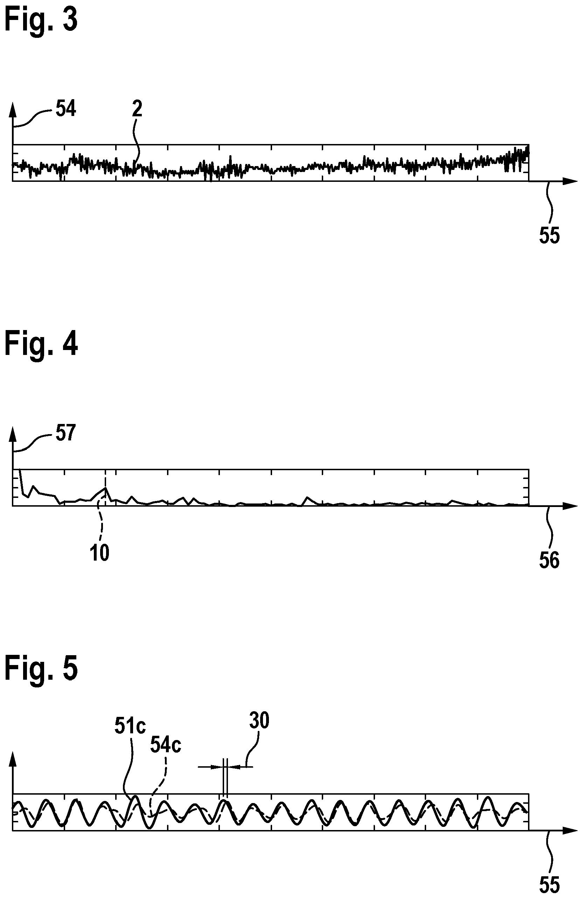

Ein beispielhafter Verlauf für ein erfasstes Geschwindigkeitssignal 2 ist in den Figuren 2 und 3 dargestellt. Beispielsweise in Figur 2 unten und in Figur 3 ist dabei die Geschwindigkeit 54 in Abhängigkeit der Zeit 55 dargestellt.

Anschließend erfolgt bei dem Verfahren ein Ermitteln eines Frequenzspektrums 20 des Geschwindigkeitssignals 2. Das Ermitteln des Frequenzspektrums 20 erfolgt mittels einer schnellen Fourier-Transformation. Das derart ermittelte Frequenzspektrum 20 des Geschwindigkeitssignals der Figur 3, das heißt eine Funktion der Häufigkeit 75 bestimmter auftretender Frequenzen 56 im Geschwindigkeitssignal 2, ist in Figur 4 dargestellt.

Wie in Figur 4 zu erkennen, liegt dabei ein Peak der Frequenzverteilung bei einer charakteristischen Frequenz 10 vor. Die Hälfte dieser charakteristischen Frequenz entspricht dabei der zu ermittelnden Trittfrequenz, mit der der Fahrer des Fahrrads 100 in die Pedale tritt.

Diese Ermittlung basiert auf der Annahme, dass die momentane Geschwindigkeit des Fahrrads 100 aufgrund der Pedalbetätigung durch den Fahrer schwankt. Das entsprechende bei der Pedalbetätigung aufgebrachte Tretmoment ist dabei insbesondere von der momentanen Pedalstellung abhängig. Das heißt, bei einer horizontalen Pedalstellung wird durch die in dieser Stellung maximale Tretkraft des Fahrers das maximale Tretmoment erzeugt, während in vertikaler Stellung das jeweils geringste Tretmoment erzeugt wird.

Ein derartiger schwankender Drehmomentverlauf ist ebenfalls in der Figur 2 zu erkennen, in der ein den Drehmomentverlauf repräsentierendes Drehmomentsignal 3 im obersten Diagramm dargestellt ist. Hierbei ist das momentane Fahrerdrehmoment 51 in Abhängigkeit der Zeit 55 dargestellt.

Mittels der ermittelten Trittfrequenz kann anschließend das Geschwindigkeitssignal 2, das mittels des Geschwindigkeitssensors 103 erfasst wird, plausibilisiert werden. Insbesondere kann dies in Abhängigkeit eines momentanen vorbekannten Übersetzungsverhältnisses eines Antriebs des Fahrrads 100 erfolgen. Anhand des vorbekannten Übersetzungsverhältnisses kann beispielsweise basierend auf der ermittelten Trittfrequenz eine zu erwartende momentane Geschwindigkeit berechnet werden. Durch Vergleich der derart berechneten Geschwindigkeit mit der momentanen Geschwindigkeit des Geschwindigkeitssignals 2 kann eine Validierung des Geschwindigkeitssignals 2 erfolgen. Im Falle einer Implausibilität Geschwindigkeitssignals 2 kann dadurch beispielsweise auf eine Manipulation der Geschwindigkeitserfassung geschlossen werden. Falls eine derartige Manipulation erkannt wird, können beispielsweise weitere Maßnahmen ergriffen werden, wie eine Deaktivierung der Antriebseinheit 102, um beispielsweise zuverlässig eine Motorunterstützung oberhalb der vorbestimmten Maximal-Geschwindigkeit zu verhindern.

Ferner kann durch die basierend auf der Geschwindigkeitserfassung ermittelte Trittfrequenz auf besonders einfache und kostengünstige Weise eine Validierung eines dedizierten Trittfrequenz-Sensors 107 erfolgen.

Eine weitere Optimierung des Verfahrens kann erfolgen, indem zusätzlich eine Erfassung des Drehmomentsignals 3, das das momentane Fahrerdrehmoment repräsentiert, erfolgt. Dabei kann zwischen dem ermittelten Geschwindigkeitssignal 2 und dem Drehmomentsignal 3 ein Phasenversatz 30 ermittelt werden, wie in Figur 2 dargestellt. Ebenfalls ist der Phasenversatz 30 anhand der Figur 5 zu erkennen, in welcher ein gefiltertes Drehmomentsignal 51c und ein gefiltertes Geschwindigkeitssignal 54c dargestellt ist.

Dieser Phasenversatz 30 resultiert dabei aus mechanischen und/oder klimatischen Zusammenhängen der Kraftübertragung zwischen der Pedalbetätigung durch die Muskelkraft des Fahrers und dem Antrieb am Hinterrad des Fahrrads 100. Beispielsweise teilt sich dieser gesamte Phasenversatz 30 in mehrere einzelne Phasenversätze auf, wie nachfolgend beschrieben.

Im zweiten Diagramm der Figur 2 ist dabei ein Gesamt-Momentenverlauf 52a, der ein Gesamt-Moment 52, das eine Summe aus dem Fahrerdrehmoment 51 und einem erzeugten Motordrehmoment der Antriebseinheit 102 ist, über die Zeit 55 dargestellt. Zwischen dem Drehmomentsignal 3 und dem Gesamt-Momentenverlauf 52a resultiert dabei ein erster Phasenversatz 52b durch eine Drehmomentfilterung in der Motorsteuerung der Antriebseinheit 102.

Im dritten Diagramm der Figur 2 ist ein Beschleunigungs-Verlauf 53a dargestellt, der eine Beschleunigung 53 des Fahrrads 100 in Abhängigkeit der Zeit 55 anzeigt. Zwischen dem Gesamt-Momentenverlauf 52a und dem Beschleunigungs-Verlauf 53a resultiert ein zweiter Phasenversatz 53b durch eine Trägheit und/oder Elastizität und durch Reibungseinflüsse im Antriebsstrang des Fahrrads 100.

Ferner ist in Figur 2 ein dritter Phasenversatz 54b zwischen dem Beschleunigungs-Verlauf 53a und dem Geschwindigkeitssignal 2 gekennzeichnet, welcher sich durch den physikalischen Zusammenhang des Nacheilens der Geschwindigkeit bezüglich der Beschleunigung ergibt.

Somit ergibt sich insgesamt der gesamte Phasenversatz 30 zwischen dem Drehmomentsignal 3 und dem Geschwindigkeitssignal 2.

Basierend auf der entsprechenden Ermittlung des Phasenversatzes 30 und den vorbekannten mechanischen und kinematischen Eigenschaften des Antriebs des Fahrrads 100 kann dabei ebenfalls ein Plausibilisieren des ermittelten Geschwindigkeitssignals 2 erfolgen. Beispielsweise kann dies durch Vergleich des ermittelten Phasenversatzes 30 mit einem zu erwartenden Phasenversatz, der beispielsweise berechnet, oder als vorbestimmter Wert vorgegeben, oder aus einer Tabelle ermittelt sein kann.

## Patentansprüche

1. Verfahren zum Ermitteln einer Trittfrequenz eines Fahrrads (100), insbesondere eines Elektrofahrrads, umfassend die Schritte:
- Ermitteln eines Bewegungssignals (2), das einen zeitlichen Verlauf einer Fortbewegung des Fahrrads (100) repräsentiert,
- Ermitteln eines Frequenzspektrums (20) des Bewegungssignals (2), und
- Ermitteln einer Trittfrequenz basierend auf dem ermittelten Frequenzspektrum (20), das Verfahren ist **gekennzeichnet durch**
- Plausibilisieren des ermittelten Bewegungssignals (2) mittels der ermittelten Trittfrequenz, insbesondere basierend auf einem vorbekannten Übersetzungsverhältnis eines Antriebs des Fahrrads (100)
- Ermitteln eines Phasenversatzes (30) zwischen dem Bewegungssignal (2) und einem Drehmomentsignal (3), das ein momentanes Fahrerdrehmoment oder ein Gesamtdrehmoment repräsentiert.

2. Verfahren nach Anspruch 1, ferner umfassend den Schritt: Ermitteln einer charakteristischen Frequenz (10) des Frequenzspektrums (20) des Bewegungssignals (2), wobei das Ermitteln der Trittfrequenz basierend auf der ermittelten charakteristischen Frequenz (10) erfolgt.

3. Verfahren nach Anspruch 2, wobei die Trittfrequenz als halbe Frequenz der charakteristischen Frequenz (10) ermittelt wird.

4. Verfahren nach einem der vorhergehenden Ansprüche, wobei das Ermitteln des Frequenzspektrums (20) mittels einer schnellen Fourier-Transformation durchgeführt wird.

5. Verfahren nach einem der vorhergehenden Ansprüche, wobei das Bewegungssignal (2) ein Geschwindigkeitssignal (2) aufweist, und wobei das Ermitteln des Geschwindigkeitssignals (2) mittels eines Geschwindigkeitssensors (103), insbesondere einem Reed-Sensor und/oder einem Antiblockier-Sensor, erfolgt.

6. Verfahren nach einem der vorhergehenden Ansprüche, wobei das Bewegungssignal (2) ein Beschleunigungssignal (2) aufweist, und wobei das Ermitteln des Beschleunigungssignals (2) mittels eines Beschleunigungssensors, insbesondere einer Inertialsensorik, erfolgt.

7. Verfahren nach einem der vorhergehenden Ansprüche, ferner umfassend die Schritte:
- Ermitteln einer Sensor-Trittfrequenz mittels eines Trittfrequenz-Sensors (107), und
- Validieren des Trittfrequenz-Sensors (107) basierend auf einem Vergleich der ermittelten Trittfrequenz und der ermittelten Sensor-Trittfrequenz.

8. Verfahren nach einem der Ansprüche 1 bis 7, ferner umfassend den Schritt:
- Ermitteln einer Manipulation des Bewegungssignals (2) im Ansprechen auf eine ermittelte Implausibilität des Bewegungssignals (2).

9. Verfahren nach einem der Ansprüche 1 bis 8, wobei das Plausibilisieren zusätzlich basierend auf dem ermittelten Phasenversatz (30) durchgeführt wird.

10. Verfahren zum Betreiben einer Antriebseinheit (102) eines Elektrofahrrads (100), umfassend die Schritte:
- Ermitteln einer Trittfrequenz des Elektrofahrrads (100) mittels eines Verfahrens nach einem der vorhergehenden Ansprüche, und
- Betätigen der Antriebseinheit (102) in Abhängigkeit der ermittelten Trittfrequenz.

11. Verfahren nach Anspruch 10, ferner umfassend den Schritt:
- Ermitteln einer Manipulation des Bewegungssignals (2) im Ansprechen auf eine ermittelte Implausibilität des Bewegungssignals (2)
- Deaktivieren der Antriebseinheit (102) im Ansprechen auf eine ermittelte Manipulation des Bewegungssignals (2).

12. Fahrrad, insbesondere Elektrofahrrad, umfassend:
- einen Geschwindigkeitssensor (103) und/oder eine Inertialsensorik zum Erzeugen eines Bewegungssignals (2), einen zeitlichen Verlauf einer Fortbewegung des Fahrrads (100) repräsentiert, und
- eine Steuereinheit (108), welche eingerichtet ist zur Durchführung eines Verfahrens nach einem der vorhergehenden Ansprüche.

## Claims

1. Method for determining a cadence of a bicycle (100), in particular an electric bicycle, comprising the following steps:
- determining a movement signal (2) representing a time profile of the locomotion of the bicycle (100),
- determining a frequency spectrum (20) of the movement signal (2), and
- determining a cadence based on the determined frequency spectrum (20), the method being **characterized by**
- checking the plausibility of the determined movement signal (2) by means of the determined cadence, in particular based on a previously known transmission ratio of a drive of the bicycle (100),
- determining a phase offset (30) between the movement signal (2) and a torque signal (3) representing an instantaneous torque applied by the cyclist or an overall torque.

2. Method according to Claim 1, further comprising the following step: determining a characteristic frequency (10) of the frequency spectrum (20) of the movement signal (2), wherein the cadence is determined based on the determined characteristic frequency (10).

3. Method according to Claim 2, wherein the cadence is determined as half the frequency of the characteristic frequency (10).

4. Method according to any one of the preceding claims, wherein the frequency spectrum (20) is determined by means of a fast Fourier transformation.

5. Method according to any one of the preceding claims, wherein the movement signal (2) includes a speed signal (2), and wherein the speed signal (2) is determined by means of a speed sensor (103), in particular a reed sensor and/or an anti-lock sensor.

6. Method according to any one of the preceding claims, wherein the movement signal (2) includes an acceleration signal (2), and wherein the acceleration signal (2) is determined by means of an acceleration sensor, in particular an inertial sensor system.

7. Method according to any one of the preceding claims, further comprising the following steps:
- determining a sensor cadence by means of a cadence sensor (107), and
- validating the cadence sensor (107) based on a comparison of the determined cadence and the determined sensor cadence.

8. Method according to any one of Claims 1 to 7, further comprising the following step:
- determining a manipulation of the movement signal (2) in response to a determined implausibility of the movement signal (2).

9. Method according to any one of Claims 1 to 8, wherein the plausibility is additionally checked based on the determined phase offset (30).

10. Method for operating a drive unit (102) in an electric bicycle (100), comprising the following steps:
- determining a cadence of the electric bicycle (100) by means of a method according to any one of the preceding claims, and
- actuating the drive unit (102) depending on the determined cadence.

11. Method according to Claim 10, further comprising the following step:
- determining a manipulation of the movement signal (2) in response to a determined implausibility of the movement signal (2),
- deactivating the drive unit (102) in response to a detected manipulation of the movement signal (2).

12. Bicycle, in particular electric bicycle, comprising:
- a speed sensor (103) and/or an inertial sensor system for generating a movement signal (2) representing a time profile of the locomotion of the bicycle (100), and
- a control unit (108) which is configured to carry out a method according to any one of the preceding claims.

## Revendications

1. Procédé permettant de déterminer une fréquence de pédalage d'un vélo (100), en particulier d'un vélo électrique, comprenant les étapes consistant à :
- déterminer un signal de mouvement (2) qui représente une courbe de temps d'un déplacement du vélo (100),
- déterminer un spectre de fréquence (20) du signal de mouvement (2), et
- déterminer une fréquence de pédalage sur la base du spectre de fréquence (20) déterminé, le procédé étant **caractérisé par** les étapes consistant à
- contrôler la plausibilité du signal de mouvement (2) au moyen de la fréquence de pédalage déterminée, en particulier sur la base d'un rapport de transmission préalablement connu d'un système d'entraînement du vélo (100),
- déterminer un déphasage (30) entre le signal de mouvement (2) et un signal de couple (3) qui représente un couple instantané exercé par le cycliste ou un couple total.

2. Procédé selon la revendication 1, comprenant en outre l'étape consistant à : déterminer une fréquence caractéristique (10) du spectre de fréquence (20) du signal de mouvement (2), dans lequel la détermination de la fréquence de pédalage est effectuée sur la base de la fréquence caractéristique déterminée (10).

3. Procédé selon la revendication 2, dans lequel la fréquence de pédalage est déterminée sous la forme de la moitié de la fréquence caractéristique (10).

4. Procédé selon l'une quelconque des revendications précédentes, dans lequel la détermination du spectre de fréquence (20) est effectuée au moyen d'une transformation de Fourier rapide.

5. Procédé selon l'une quelconque des revendications précédentes, dans lequel le signal de mouvement (2) présente un signal de vitesse (2), et dans lequel la détermination du signal de vitesse (2) est effectuée au moyen d'un capteur de vitesse (103), en particulier d'un capteur Reed et/ou d'un capteur antiblocage.

6. Procédé selon l'une quelconque des revendications précédentes, dans lequel le signal de mouvement (2) présente un signal d'accélération (2), et dans lequel la détermination du signal d'accélération (2) est effectuée au moyen d'un capteur d'accélération, en particulier d'un système de capteurs à inertie.

7. Procédé selon l'une quelconque des revendications précédentes, comprenant en outre les étapes consistant à :
- déterminer une fréquence de pédalage de capteur au moyen d'un capteur de fréquence de pédalage (107), et
- valider le capteur de fréquence de pédalage (107) sur la base d'une comparaison de la fréquence de pédalage déterminée et de la fréquence de pédalage de capteur déterminée.

8. Procédé selon l'une quelconque des revendications 1 à 7, comprenant en outre l'étape consistant à :
- déterminer une manipulation du signal de mouvement (2) en réponse à un manque de plausibilité déterminé du signal de mouvement (2).

9. Procédé selon l'une quelconque des revendications 1 à 8, dans lequel le contrôle de plausibilité est en outre effectué sur la base du déphasage (30) déterminé.

10. Procédé permettant de faire fonctionner une unité d'entraînement (102) d'un vélo électrique (100), comprenant les étapes consistant à :
- déterminer une fréquence de pédalage du vélo électrique (100) au moyen d'un procédé selon l'une quelconque des revendications précédentes, et
- actionner l'unité d'entraînement (102) en fonction de la fréquence de pédalage déterminée.

11. Procédé selon la revendication 10, comprenant en outre l'étape consistant à :
- déterminer une manipulation du signal de mouvement (2) en réponse à un manque de plausibilité déterminé du signal de mouvement (2),
- désactiver l'unité d'entraînement (102) en réponse à une manipulation déterminée du signal de mouvement (2).

12. Vélo, en particulier vélo électrique, comprenant :
- un capteur de vitesse (103) et/ou un système de capteurs à inertie pour produire un signal de mouvement (2) qui représente une courbe de temps d'un déplacement du vélo (100), et
- un dispositif de commande (108) qui est conçu pour exécuter un procédé selon l'une quelconque des revendications précédentes.
